# EUROPÄISCHE PATENTSCHRIFT

(11) **EP 1 231 475 B1**
(45) Veröffentlichungstag und Bekanntmachung des Hinweises auf die Patenterteilung: **28.02.2007**
(21) Anmeldenummer: 01126904.0
(22) Anmeldetag: 13.11.2001
(51) Int. Cl.: G01R 31/36, G05B 23/02, G05B 13/04, G05B 17/02

(54) **Verfahren und Vorrichtung zur Zustandserfassung von technischen Systemen wie Energiespeicher**
Procedure and method of determining the state of a technical system such as an energy storage
Procédé et appareil de détermination de l'état d'un système technique tel qu'un accumulateur d'énergie

(30) Priorität: 13.02.2001 DE 10106505
(43) Veröffentlichungstag der Anmeldung: 14.08.2002
(73) Patentinhaber: ROBERT BOSCH GMBH, 70442 Stuttgart (DE)
(72) Erfinder: Sarfert, Christel, 70174 Stuttgart (DE)

(56) Entgegenhaltungen:
- EP-A- 0 505 333
- WO-A-00/41042
- US-A- 5 144 595
- US-A- 5 394 322
- SOATTO, S., CHIUSO, A.: "Dynamic Data Factorisation" TECHNICAL REPORT UCLA-CSD 010001, - 6. März 2000 (2000-03-06) Seiten 1-7, XP002274397
- WEI-YONG YAN, LIHUA XIE, JAMES LAM: "Convergent algorithms for frequency weighted L2 model reduction" SYSTEMS & CONTROL LETTERS , Bd. 31, - 20. November 1997 (1997-11-20) Seiten 11-20, XP002274398
- TORIKAI T ET AL: "Research and development of model-based battery state of charge indicator" SIGNAL PROCESSING AND SYSTEMS CONTROL, INTELLIGENT SENSORS AND INSTRUMENTATION. SAN DIEGO, NOV. 9 - 13, 1992, PROCEEDINGS OF THE INTERNATIONAL CONFERENCE ON INDUSTRIAL ELECTRONICS,CONTROL, INSTRUMENTATION AND AUTOMATION (IECON), NEW YORK, IEEE, US, Bd. 3 CONF. 18, 9. November 1992 (1992-11-09), Seiten 996-1001, XP010060504 ISBN: 0-7803-0582-5

## Beschreibung

### Gebiet der Erfindung

Die Erfindung betrifft ein Verfahren zur Zustandserfassung eines technischen Systems, insbesondere eines Energiespeichers, bei dem Betriebsgrößen gemessen und einer Zustandsschätzroutine zugeführt werden, die mittels eines auf systemabhängigen Modellparametern und den gemessenen Betriebsgrößen basierenden Modells den aktuellen Systemzustand charakterisierende Zustandsgrößen bestimmt, wobei zur Verbesserung der Zustandsschätzung die gemessenen Betriebsgrößen und eventuell die bestimmten Zustandsgrößen zusätzlich einer Parameterschätzroutine zugeführt werden können, die ihrerseits die Modellparameter nutzungsabhängig durch Schätzung bestimmt. Die Erfindung betrifft weiterhin eine entsprechende Vorrichtung und ein Computerprogramm zur Durchführung des Verfahrens sowie ein Computerprogrammprodukt.

### Stand der Technik

Aus der deutschen Patentanmeldung DE-199 59 019.2 ist ein gattungsgemäßes Verfahren zur Batteriezustandserkennung beschrieben. Ausgehend von messbaren Betriebsgrößen, wie Strom, Spannung und Temperatur, werden dort Zustandsgrößen mittels eines Modells, das in Form eines (Kalman-)Filters implementiert ist, durch Schätzung bestimmt. Da die Parameter des Modells sich aufgrund der Alterung der Batterie sowie durch mögliche plötzlich auftretende Defekte verändern, ist zusätzlich eine Parameterschätzroutine vorgesehen, um diese Parameterveränderungen online mitverfolgen und die Parameter entsprechend anpassen zu können. Die aktuellen Parameter werden dann der Zustandsschätzroutine, also dem Filter, zugeführt. Dadurch wird erreicht, dass das Modell ständig an den tatsächlichen Zustand der Batterie adaptiert wird und das Filter keine falschen Werte für die Zustandsgrößen schätzt. Die Trennung der Schätzung von Zustandsgrößen und Parametern durch das Filter bzw. den Parameterschätzer bewirkt, dass bias-behaftete Schätzungen vermieden bzw. unwahrscheinlich werden.

Es hat sich gezeigt, dass das.beschriebene Verfahren zur Zustandserkennung mittels Schätzung sowohl der Zustandsgrößen als auch der zugrundeliegenden Modellparameter häufig nicht ausreicht, um eine geforderte Genauigkeit der geschätzten Werte zu garantieren und Divergenzen bei den zur Schätzung häufig verwendeten Kovarianzmatrizen zu vermeiden.

Es wird daher angestrebt, bei möglichst verringertem Rechen- und Speicherbedarf die Zustands- und Parameterschätzung stabiler zu gestalten und eine solche Schätzung für alle denkbaren Systemzustände zu ermöglichen.

Aus der Druckschrift "Technical Report Ucla-csd 010001, "Dynamical Data Factorisation", Soatto, S., Chiuso, Alessandro, Seite 1-7" sind Verfahren zur Zustandserfassung eines technischen Systems bekannt, bei dem Betriebsgrößen gemessen und einer Zustandsschätzroutine zugeführt werden. Dabei werden mittels eines auf systemabhängigen Modellparametern und den gemessenen Betriebsgrößen basierenden Modells aktuelle Systemzustände und charakterisierende Zustandsgrößen bestimmt, wobei zur Verbesserung der Zustandsschätzung die gemessenen Betriebsgrößen und eventuell die bestimmten Zustandsgrößen zusätzlich einer Parameterschätzroutine zugeführt. Diese bestimmt ihrerseits die Modellparameter nutzungsabhängig unter Berücksichtigung einer möglicherweise vorhandenen Dynamik der gemessenen Betriebsgrößen. Die beschriebene Verfahren laufen beispielsweise in Computerprogrammen ab, die auch Programmcode-Mittel umfassen können.

Die Druckschrift "Systems & Control Letters 31 (20.11.1997), "Convergent algorithms for frequency weighted L2 modul reduction", Yan, W.-Y., Xie, L., Lam, J" zeigt Verfahren zur Zustandserfassung eines technischen Systems bei dem Betriebsgrößen gemessen werden. Zustandsgrößen werden bei der Zustandsschätzung berücksichtigt. Eine Auswahl von durch Schätzung zu bestimmenden Zustandsgrößen kann in Abhängigkeit von der Dynamik der gemessenen Betriebsgrößen erfolgen. Beide vorstehend genannten Druckschriften betreffen allgemein mathematische Modellberechnungen.

Aus der Druckschrift "Signal Processing And Systems Control, Intelligent Sensors And Instrumentation. San Diego, Nov. 9-13, 1992, Proceedings Of the International Conference On Industrial Electronics, control, Instrumentation And Automation (iecon), New Yor, Ieee, Us (09-11-1992), 3 COND. 18, 996-1001" ist eine modellbasierte Batteriezustandserkennung bekannt, die unter Verwendung eines Computers arbeitet.

### Vorteile der Erfindung

Beim erfindungsgemäßen Verfahren werden zur Schätzung jeweils nur bestimmte Zustandsgrößen und/oder Parameter herangezogen, wobei diese Auswahl anhand der Dynamik der gemessenen Betriebsgrößen erfolgt. Eine erfindungsgemäße Vorrichtung weist somit Mittel zur Bestimmung der Dynamik der gemessenen Betriebsgrößen, beispielsweise Mittel zur Bildung des zeitlichen Gradienten der jeweiligen Betriebsgröße, sowie Auswahlmittel auf, durch die bestimmte Zustandsgrößen und/oder Parameter von den entsprechenden Schätzroutinen bestimmt werden. Solche Auswahlmittel können beispielsweise in Form von Tabellen, Stufenfunktionen oder Schwellwertfunktionen implementiert sein, durch die bestimmte Parameter bzw. Zustandsgrößen bestimmten Dynamikbereichen der Betriebsgrößen zugeordnet werden.

Zur Zustandsschätzung werden häufig sog. Kalman-Filter eingesetzt, die mit Kovarianzmatrizen der Schätzgrößen arbeiten. Kovarianzmatrizen repräsentieren auf ihrer Diagonalen die mittlere quadratische Abweichung des geschätzten vom gemessenen Wert, die übrigen Matrixelemente repräsentieren die Korrelationen zwischen den einzelnen Zustandsgrößen. Durch das erfindungsgemäße Verfahren wird die Ordnung dieser Matrizen reduziert und damit der numerische Aufwand sowie der benötigte Speicherbedarf verringert. Auch können nunmehr besser diejenigen Parameter bestimmt werden, die sich in unterschiedlichen Zeiträumen und bei unterschiedlichen Anregungen, d.h. bei den vorhandenen Betriebsgrößen, ändern.

Es ist vorteilhaft, bei hoher Dynamik der gemessenen Betriebsgrößen solche Zustandsgrößen bzw. Parameter zu schätzen, die kleine Zeitkonstanten besitzen, und diejenigen mit großer Zeitkonstante bei geringer Dynamik der gemessenen Betriebsgrößen zur Schätzung heranzuziehen. Die jeweils anderen Zustandsgrößen bzw. Parameter werden währenddessen festgehalten oder mittels eines vorgegebenen Modells nachgeführt.

Im Beispiel der Batteriezustandserkennung verwendet ein Batteriemodell verschiedene Widerstands- und Spannungsgrößen mit unterschiedlichen Zeitkonstanten. Ohmsche Werte und die sog. Durchtrittsüberspannung besitzen kleine Zeitkonstanten und werden vorzugsweise dann geschätzt, wenn die gemessenen Betriebsgrößen große Dynamik aufweisen. Hingegen besitzt beispielsweise die Konzentrationsüberspannung eine große Zeitkonstante, so dass diese Größe bei geringer Dynamik geschätzt werden kann. Die jeweils anderen Größen sind während der Schätzung festzuhalten oder entsprechend einem vorgegebenen Muster zu ändern.

Es ist weiterhin vorteilhaft, wenn vor der Schätzungsbestimmung festgestellt wird, ob sich das System in einem Grenzzustand befindet, und wenn die Zustandsgrößen bzw. Parameter nur dann geschätzt werden, wenn sich das System nicht in einem solchen Grenzzustand befindet. Derartige Grenzzustände liegen beispielsweise am Anfang und am Ende der Lebensdauer eines technischen Systems vor. Im Beispiel der Batteriezustandserkennung heißt dies, dass in einer Situation, in der die Batterie nahezu voll geladen ist, auf genauere Schätzwerte verzichtet werden kann, da dieser Grenzzustand ein gewünschter und nicht kritischer Bereich ist. Ein anderer Fall liegt vor, wenn die Batterie in einen sehr schlechten (Lade-)Zustand gerät. Da dies im Regelfall ausreichend früh erkannt wird und somit ein vollständiges Versagen der Batterie vermieden werden kann, ist dieser Grenzzustand ebenfalls nicht von besonderer Relevanz.

Durch dieses Ausblenden der Schätzung in den Grenzbereichen der Modellgenauigkeit werden Divergenzen des Filters/Schätzers und schlechte Qualitäten der ermittelten Größen vermieden. Verschlechtert sich beispielsweise der Ladezustand einer vollgeladenen Batterie wieder, gerät die Batterie automatisch in einen Arbeitspunkt, in dem das verwendete Modell volle Gültigkeit besitzt und ein Kalman-Filter Schätzgrößen großer Güte liefern kann. Vorteile ergeben sich auch im Hinblick auf die benötige Hardware. Man erreicht dadurch geringere numerische Komplexität, somit eine geringere Auslastung des Prozessors und geringere Anforderungen an den Speicherbedarf im RAM.

Bei dem erfindungsgemäßen Verfahren ist es weiterhin sinnvoll, die Güte der Schätzungsbestimmung anhand einer bereits erwähnten Kovarianzmatrix zu kontrollieren. Je kleiner nämlich der Wert in dieser Kovarianzmatrix für die jeweilige Zustandsgröße ist, desto wahrscheinlicher oder genauer ist der geschätzte Wert dieser Größe. Das gleiche gilt für die Parameterschätzung. Auch hier hat man bei den gängigen Schätztheorien (z. B. Bayes-, Maximum-Likelihood-Methode) sog. Kovarianzmatrizen, die eine Aussage über die Güte der Parameterschätzung und/oder die Genauigkeit der geschätzten Parameter machen. Die Vorgehensweise ist hier dann in etwa die gleiche wie beim Zustandsschätzer. Die Konvergenz (auf Werte nahe Null) der den Schätzgrößen zugeordneten Matrixgrößen kann dazu verwendet werden, die Güte der Schätzung zu beurteilen. Außerdem lässt sich durch entsprechende Gewichtung der ermittelten Ergebnisse die Gesamtaussage bezüglich der Zustandsgrößen, wie Lade- und Alterungszustand der Batterie, noch erhöhen.

Ein einfacher Weg zur Gütebestimmung der Schätzung ist die Festlegung eines Schwellenwertes für den der jeweiligen Schätzgröße zugeordneten Matrixwert. Diese Schwellenwerte werden durch Erfahrungswerte bestimmt und liegen in der Regel nahe bei Null.

Weisen die geschätzten Werte nur geringe Güte auf, können andere, sog. "Back-up"-Verfahren stärker gewichtet in die Auswertung mit einfliessen. Mittels derartiger "Back-up"-Verfahren werden die jeweiligen Größen festgehalten oder entsprechend einfacher Modelle, die nicht zu Divergenzen führen, angepasst. Auf der anderen Seite kann entschieden werden, dass beispielsweise gewisse Parameter augenblicklich nicht von der Zustandsschätzroutine übernommen werden oder gewisse Zustände augenblicklich die Parameterschätzroutine nicht initiieren dürfen.

Die Erfindung wird im folgenden anhand eines durch die beigefügten Zeichnungen illustrierten Ausführungsbeispiels näher erläutert.

Fig. 1 zeigt die schematische Anordnung der Komponenten einer erfindungsgemäßen Vorrichtung zur Zustandserfassung eines Energiespeichers.

Fig. 2 zeigt ein schematisches Beispiel für die Konvergenz einer Zustandsgröße und der zugehörigen Kovarianz.

Fig. 3 zeigt schematisch ein Beispiel für die Divergenz einer geschätzten Zustandsgröße und die zugehörige Kovarianz.

Fig. 4 zeigt ein Flussdiagramm eines Ausführungsbeispiels des erfindungsgemäßen Verfahrens.

Fig. 5 zeigt ein Flussdiagramm zur Bestimmung der Güte der geschätzten Größen.

Das vorliegende Ausführungsbeispiel kann auf eine Zustandserkennung für Energiespeicher wie Autobatterien gelesen werden, ist jedoch hierauf nicht beschränkt.

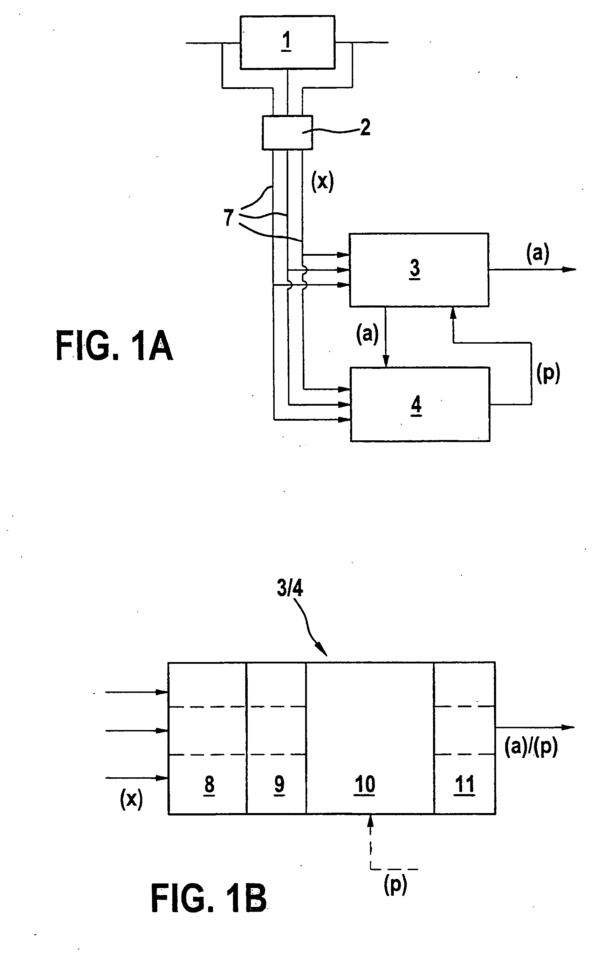

In Fig. 1 sind schematisch die Komponenten zur erfindungsgemäßen Zustandserfassung eines Energiespeichers 1, wie eine Autobatterie, dargestellt. Eine Sensor- und Messeinheit 2 nimmt Messungen von Betriebsgrößen x, wie Strom, Spannung und/oder Temperatur, an der Batterie 1 vor. Die gemessenen Betriebsgrößen werden über Leitungen 7 einem Zustandsschätzer 3 zugeführt, der beispielsweise mittels eines Kalman-Filters in bekannter Weise Zustandsgrößen bestimmt, die den aktuellen Systemzustand charakterisieren. Solche Zustandsgrößen a können die verfügbare Ladung oder das Alter der Batterie 1 sein. Zur Ermittlung dieser Zustandsgrößen a greift der Zustandsschätzer 3 auf ein Modell zurück, in das die gemessenen Betriebsgrößen x eingegeben werden. Das Modell selbst arbeitet mit Modellparametern p, die ebenfalls von Alterungsprozessen des Energiespeichers 1 abhängig sind. Um zu vermeiden, dass das Modell aufgrund veränderter Parameter p seine Gültigkeit verliert, werden die Modellparameter p mittels eines Parameterschätzers 4 aktualisiert. Hierfür wird eine Parameterschätzroutine verwendet, die als Eingangsgrößen die gemessenen Betriebsgrößen x und eventuell zusätzlich die geschätzten Zustandsgrößen a verwendet. Die aktualisierten Parameter p werden dann dem Zustandsschätzer 3 übergeben. Hierzu sind Zustandsschätzer 3 und Parameterschätzer 4 miteinander verbunden.

Die vom Zustandsschätzer 3 bestimmten Zustandsgrößen a werden weiterverarbeitet, um jeweils günstige Maßnahmen (beispielsweise Ladezustandsanzeige, Modifizierung der Energieversorgung) zu ergreifen.

Fig. 1B zeigt einen für den Zustandsschätze 3 sowie für den Parameterschätzer 4 gleichsam geeigneten Aufbau, bei dem die einzelnen Komponenten zur erfindungsgemäßen Zustandserfassung jeweils in einer Einheit zusammengefasst vorliegen. Über Leitungen 7 werden dem Zustandsschätzer 3 bzw. dem Parameterschätzer 4 die gemessenen Betriebsgrößen x zugeführt. Als Mittel 8 zur Erfassung der Dynamik der gemessenen Betriebsgrößen x sind Differenzenbildner oder Differenziatoren vorgesehen, die jeweils den Gradienten einer Messgröße x bilden. Nachgeschaltet ist eine Auswahleinheit 9, die abhängig von der erfassten Dynamik dieser Betriebsgrößen x diejenigen Zustandsgrößen a bzw. Parameter p auswählt, die nachfolgend geschätzt werden sollen. Die ausgewählten Betriebsgrößen x werden beim Zustandsschätzer 3 zusammen mit den aktualisierten Parametern p einer Berechnungseinheit 10 zugeführt, die mittels eines Modells bestimmte Zustandsgrößen a berechnet. Die meisten Schätzmodelle arbeiten mit sogenannten Kovarianzmatrizen, deren den einzelnen Zustandsgrößen zugeordnete Werte gegen Null konvergieren, wenn der geschätzte Wert sich zeitlich dem realen Wert annähert. Diese Matrixwerte (Kovarianzen) können demnach zur Beurteilung der Güte der Schätzung herangezogen werden.

Zur Beurteilung der Güte der Schätzung werden in einer Einheit 11 beispielsweise zu den jeweiligen Kovarianzen gehörende Schwellenwerte festgelegt und durch Differenzbildung des geschätzten Wertes mit dem festgelegten Schwellenwert die Güte der Schätzung bestimmt. Unterschreitet beispielsweise eine geschätzte Zustandsgröße nach einer vorgegebenen Zyklenzahl nicht diesen Schwellenwert, so kann der geschätzte Wert verworfen und statt dessen der vorher geschätzte Wert beibehalten werden. Auf diese Weise verhindert man eine zunehmende Verschlechterung der Schätzung.

Weiter Einzelheiten und weitere Möglichkeiten der Erfindung ergeben sich aus den nachfolgenden Figuren.

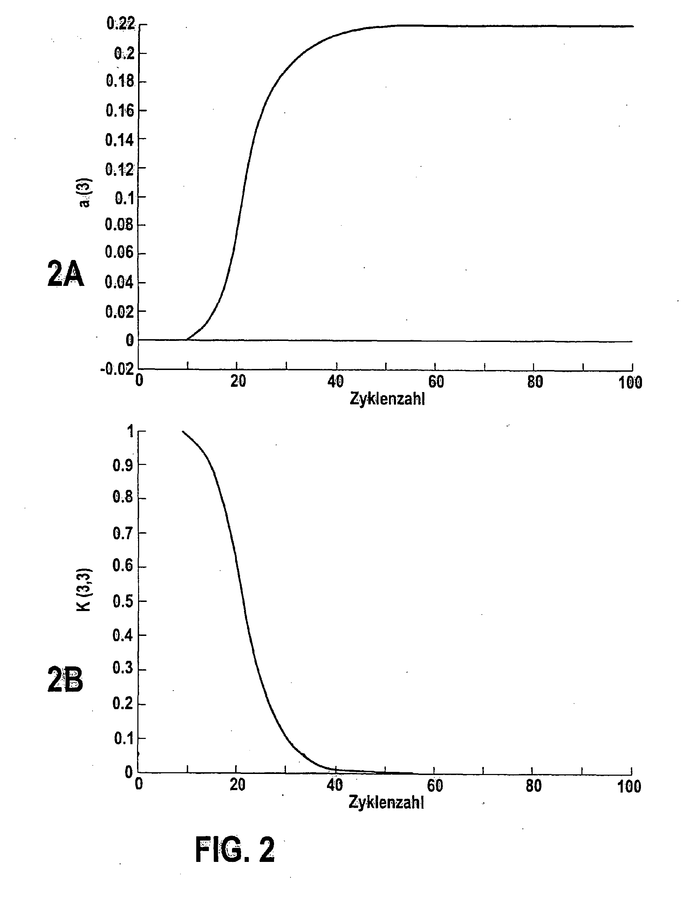

Fig. 2A zeigt ein Beispiel für eine rasch konvergierende geschätzte Zustandsgröße a(3), die nach Konvergenz keinen Schwankungen unterliegt. Solche Zustandsgrößen, wie beispielsweise die Konzentrationsüberspannung, besitzen große Zeitkonstanten. Das in Fig. 2B dargestellte, zugehörige Matrixelement der Kovarianzmatrix, hier K(3,3) zu a(3), also die sog. Kovarianz zu dieser Zustandsgröße, konvergiert rasch gegen Null. Zur Überprüfung der Güte der Schätzung lässt sich ein Schwellenwert festlegen, der nach einer bestimmten Zyklenzahl, also Anzahl iterativer Schätzungen, erreicht sein sollte. Ist dies nicht der Fall, kann die Schätzung für diese Zustandsgröße verworfen werden.

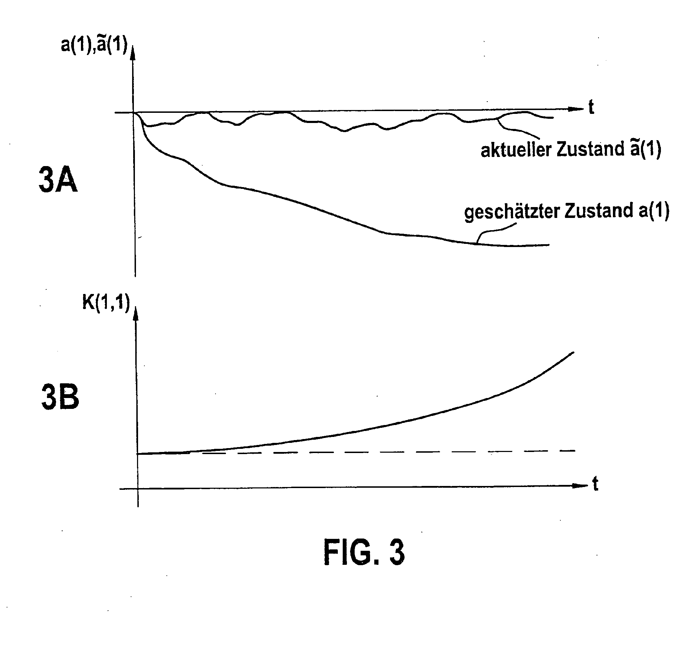

Ein Beispiel für eine Divergenz einer aktueller Zustandsgröße ã(1) und dem zugehörigen geschätzten Wert a(1) zeigt Fig. 3, wobei in Fig. 3A der unterhalb der Nulllinie pendelnde zeitliche Verlauf der aktuellen Zustandsgröße ã (1) sowie der zeitlich sich von der Nulllinie entfernende geschätzte Zustandswert a(1) dargestellt sind. Dass diese Schätzung ungeeignet ist, reflektiert die zugehörige Kovarianz, K(1,1) zur Zustandsgröße a(1). Die Kovarianz konvergiert nicht, sondern nimmt zeitlich stetig zu, wie in Fig. 3B dargestellt.

Durch die Erfindung werden Fälle, wie in Fig. 3 dargestellt, dadurch vermieden, dass bei nicht ausreichender Güte der Schätzung auf sog. "Back-up"-Verfahren zurückgegriffen wird.

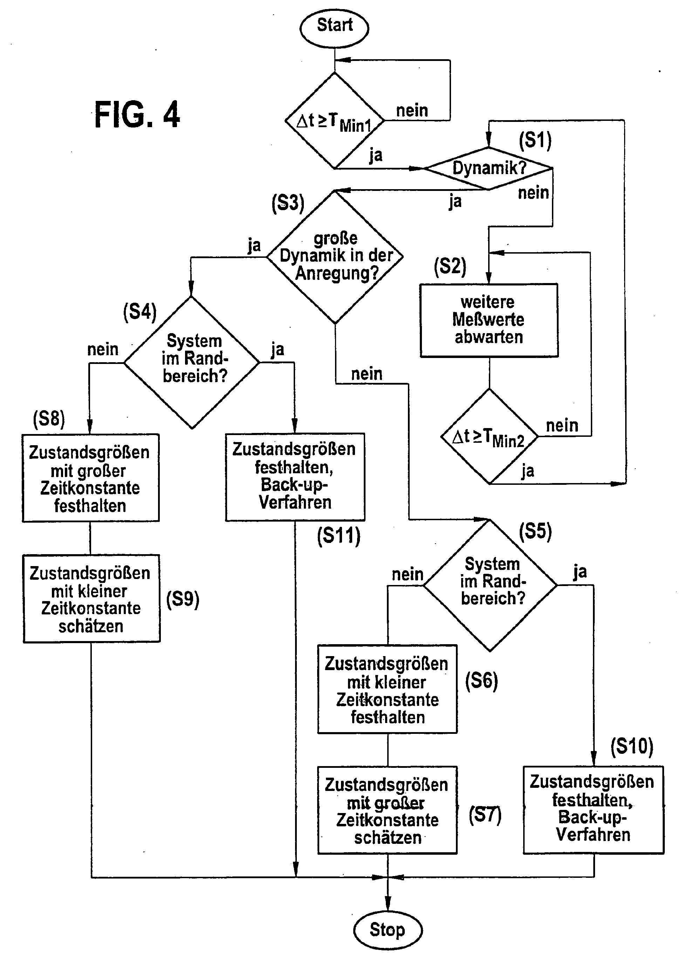

Fig. 4 zeigt das Flussdiagramm eines Beispiels zur Ausführung des erfindungsgemäßen Verfahrens. Zu Beginn des Schätzverfahrens wird zunächst eine bestimmte Zeit Tₘᵢₙ₁ abgewartet, bis das System einen zur Zustandsschätzung geeigneten Zustand eingenommen hat, bevor das eigentliche Schätzverfahren beginnt. Anschließend wird die Dynamik der Anregung, d.h. die Dynamik der gemessenen Betriebsgrößen x abgefragt (S1). Dies sind beispielsweise die zeitabhängigen Größen Strom, Temperatur und Spannung. Bleibt beispielsweise der Entladestrom der Batterie über einen längeren Zeitraum nahezu Null, da beispielsweise die Verbraucher vollständig vom Generator versorgt werden, so ist nicht damit zu rechnen, dass bestimmte vom Strom abhängige Zustandsgrö-ßen a oder Parameter p einer Änderung unterliegen. Es werden dann weitere Messwerte abgewartet, bis ein weiteres Zeitintervall Tₘᵢₙ₂ verstrichen ist (S2).

Setzt eine Dynamik der gemessenen Betriebsgrößen ein, wird die Größe dieser Dynamik abgefragt (S3). Bei geringer Dynamik der Messwerte wird zunächst festgestellt, ob sich das System in einem Grenzzustand oder Randbereich befindet (bei Batterien beispielsweise der vollgeladene oder der entleerte Zustand). Die gleiche Abfrage findet auch im Falle einer großen Dynamik der gemessenen Betriebsgrößen statt (S4 bzw. S5) .

Befindet sich das System nicht in einem Randbereich, so kann mit der eigentlichen Schätzung der Zustandsgrößen begonnen werden. Erfindungsgemäß werden bei geringer Dynamik der Messwerte die Zustandsgrößen mit kleiner Zeitkonstante festgehalten (S6), während die Zustandsgrößen mit großer Zeitkonstante geschätzt werden (S7). Umgekehrt werden bei Messwerten mit großer Dynamik die Zustandsgrößen mit großer Zeitkonstante festgehalten (S8), während die Zustandgrößen mit kleiner Zeitkonstante geschätzt werden (S9). Bei dem hier behandelten Batteriemodell stellen, wie bereits erwähnt, die ohmschen Werte sowie die Durchtrittsüberspannung Zustandsgrößen/Parameter mit kleinen Zeitkonstanten, hingegen beispielsweise die Konzentrationsüberspannung eine Zustandsgröße mit großer Zeitkonstante dar. Erfindungsgemäß werden diejenigen Parameter und Zustandsgrößen durch Schätzung nicht neu ermittelt, von denen aufgrund der Dynamik des Systems nicht mit Änderungen zu rechnen ist. So kann vermieden werden, dass durch unnötig häufige Schätzungen Ungenauigkeiten bei der Schätzung sich vergrößern, die dann das Modell verfälschen oder falsche Zustandsergebnisse liefern.

Wird bei der Überprüfung, ob sich das System in einem Grenzzustand (Randbereich) befindet (S4, S5), festgestellt, dass dies ist der Fall ist, werden zur Vermeidung von Fehlschätzungen (Grenzbereiche der Modellgenauigkeit) die Zustandsgrößen/Parameter beispielsweise festgehalten oder mittels "Back-up"-Verfahren ausgewertet (S10, S11). Derartige Verfahren beruhen auf stabilen Modellen, bei denen keine Divergenz zu erwarten ist.

Nach Ablauf der in Fig. 4 dargestellten Routine ist ein Zyklus der erfindungsgemäßen Zustandsschätzung beendet und weitere Zyklen können sich zeitlich unmittelbar oder mit festzulegenden Verzögerungen anschließen.

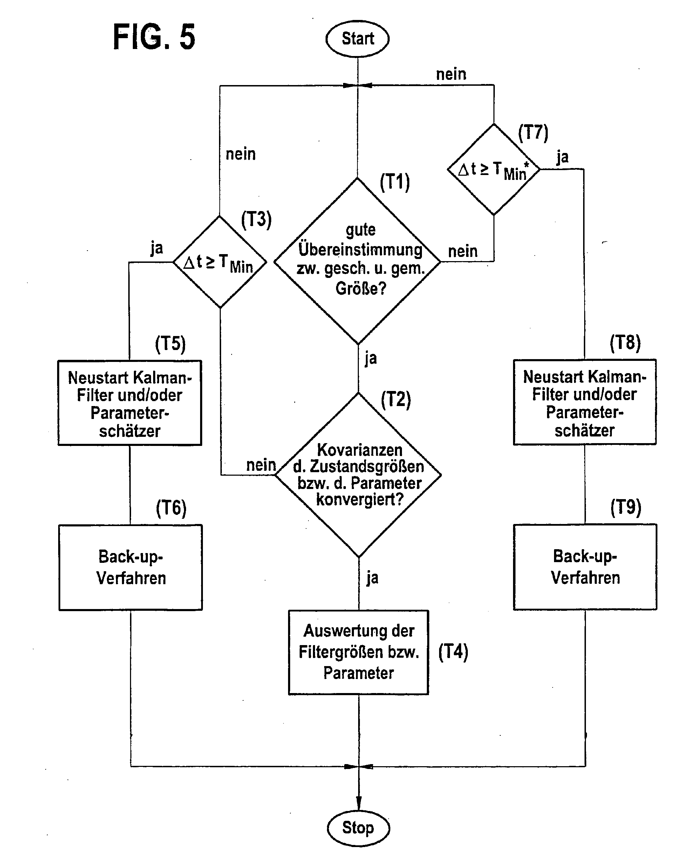

Fig. 5 zeigt ein Flussdiagramm zur Bestimmung der Güte der oben beschriebenen Schätzung. Hierzu wird zunächst eine leicht zu messende Größe, die sich aus geschätzten Größen berechnet, mit der tatsächlich gemessenen verglichen (T1). Bei guter Übereinstimmung (beispielsweise der geschätzten und der gemessenen Batteriespannung) wird die Konvergenz der zu den Zustandsgrößen/Parametern gehörenden Kovarianzen überprüft (T2). Es ist nämlich möglich, dass einzelne Kovarianzen noch nicht ausreichend konvergiert sind (siehe auch Fig. 2B), so dass in diesem Fall noch eine bestimmte typische Konvergenzzeit Tₘᵢₙ abgewartet werden muss (T3), bis sich ausreichend gute Konvergenz ergibt. Wenn dies dann der Fall ist, werden die geschätzten Zustandsgrößen/Parameter ausgewertet (T4) und hieraus beispielsweise der Ladezustand oder das Alter der Batterie bestimmt.

Ist hingegen die Zeit Tₘᵢₙ bereits verstrichen, ohne dass die zugeordneten Kovarianzen ausreichend konvergiert haben, d.h. beispielsweise einen bestimmten Schwellenwert unterschritten haben, werden die geschätzten Größen verworfen und die Parameterschätzroutine und/oder die Zustandsschätzroutine (Kalman-Filter) neu gestartet (T5). Bis zum Erhalt der neugeschätzten Größen wird auf einfache "Back-up"-Verfahren zurückgegriffen (T6).

Ergibt sich von Anfang an keine ausreichende Übereinstimmung zwischen einer einfach zu messenden und geschätzten Referenzgröße (beispielsweise Batteriespannung), so kann auch die Kovarianzmatrix nicht ausreichend konvergiert sein. Dieses Ergebnis kann nach einer Zeitdauer Tₘᵢₙ* nochmals überprüft werden (T7). Bleibt dieses Ergebnis unverändert, wird ebenfalls die Parameter- und/oder Zustandsschätzung neu gestartet (siehe Fig. 4) und auf "Back-up"-Verfahren zurückgegriffen (T8, T9).

## Patentansprüche

1. Verfahren zur Zustandserfassung eines technischen Systems (1), bei dem Betriebsgrößen (x) gemessen und einer Zustandsschätzroutine zugeführt werden, die mittels eines auf systemabhängigen Modellparametern (p) und den gemessenen Betriebsgrößen (x) basierenden Modells den aktuellen Systemzustand charakterisierende Zustandsgrößen (a) bestimmt, wobei zur Verbesserung der Zustandsschätzung die gemessenen Betriebsgrößen (x) bestimmte Zustandsgrößen (a) zusätzlich einer Parameterschätzroutine zugeführt werden, die ihrerseits die Modellparameter (p) nutzungsabhängig bestimmt und wobei abhängig von der Dynamik der gemessenen Betriebsgrößen (x) eine Auswahl von durch Schätzung zu bestimmenden Zustandsgrößen (a) und/oder Parametern (p) vorgenommen wird, **dadurch gekennzeichnet, dass** das technische System (I) ein elektrischer Energiespeicher ist, dass die nicht ausgewählten Zustandsgrößen (a) bzw. Parameter (p) unverändert festgehalten oder durch fest vorgegebene Modelle neu gesetzt werden und dass bei hoher Dynamik der gemessenen Betriebsgrößen (x) Zustandsgrößen (a) bzw. Parameter (p) mit kleiner Zeitkonstante, bei geringer Dynamik Zustandsgrößen bzw. Parameter mit großer Zeitkonstante zur Schätzung ausgewählt werden.

2. Verfahren nach Anspruch 1, **dadurch gekennzeichnet, dass** vor der Schätzung festgestellt wird, ob das System (1) sich in einem Grenzzustand befindet, insbesondere am Anfang oder am Ende seiner Lebensdauer, und dass die Zustandsgrößen (a) bzw. Parameter (p) zur Schätzung nicht ausgewählt werden, wenn sich das System (1) in einem solchen Grenzzustand befindet.

3. Verfahren nach Anspruch 1 oder 2, **dadurch gekennzeichnet,dass** die Güte der Schätzung anhand einer Kovarianzmatrix kontrolliert wird.

4. Verfahren nach Anspruch 3, **dadurch gekennzeichnet, dass** geschätzte Zustandsgrößen (a) bzw. Parameter (p) nur dann weiterverwendet werden, wenn ihre zugehörige Kovarianzen der Kovarianzmatrix konvergieren.

5. Vorrichtung zur Zustandserfassung eines technischen Systems (1) mit Mitteln (2) zur Messung der Betriebsgrößen (x) dieses Systems (1) und mit Mitteln (7) zur Zuführung der gemessenen Betriebsgrößen (x) an einen Zustandsschätzer (3), der den aktuellen Systemzustand charakterisierende Zustandsgrößen (a) mittels eines auf systemabhängigen Modellparametern (p) und den gemessenen Betriebsgrößen (x) basierenden Modells bestimmt, wobei zur Verbesserung der Zustandsschätzung zusätzlich ein Parameterschätzer (4) vorgesehen sein kann, dem die gemessenen Betriebsgrößen (x) und die bestimmten Zustandsgrößen (a) zuführbar sind, und der die Modellparameter nutzungsabhängig bestimmt, wobei Mittel (8) zur Erfassung der Dynamik der gemessenen Betriebsgrößen (x) und eine damit verbundene Auswahleinheit (9) vorgesehen sind, **dadurch gekennzeichnet, dass** das technische System ein Energiespeicher ist, dass die Auswahleinheit (9) dazu eingerichtet ist, die zu bestimmenden Zustandsgrößen (a) bzw. Parameter (p), abhängig von der erfassten Dynamik, im Zustandsschätzer und/oder Parameterschätzer (4) auswählen und dass Mittel vorgesehen sind, die bei hoher Dynamik der gemessenen Betriebsgrößen (x) Zustandsgrößen (a) bzw. Parameter (p) mit kleiner Zeitkonstante, bei geringer Dynamik Zustandsgrößen bzw. Parameter mit großer Zeitkonstante zur Schätzung auswählen und die die nicht ausgewählten Zustandsgrößen (a) bzw. Parameter (p) unverändert festhalten oder durch fest vorgegebene Modelle neu setzen.

6. Vorrichtung nach Anspruch 5, **dadurch gekennzeichnet, dass** Mittel (10) zur Berechnung einer Kovarianzmatrix für die zu bestimmenden Zustandsgrößen (a) bzw. Parameter (p) und Mittel (11) zur Auswertung der erstellten Kovarianzmatrix vorgesehen sind.

7. Computerprogramm mit Programmcode-Mitteln, um alle Schritte von wenigstens einem der Ansprüche 1 bis 4 durchzuführen, wenn das Computerprogramm auf einem Computer oder einer entsprechenden Rechnereinheit, insbesondere auf dem Zustandsschätzer (3) und/oder Parameterschätzer (4), ausgeführt wird.

8. Computerprogrammprodukt mit Programmcode-Mitteln, die auf einem computerlesbaren Datenträger gespeichert sind, um ein Verfahren nach einem der Ansprüche 1 bis 4 durchzuführen, wenn das Computerprogrammprodukt auf einem Computer oder einer entsprechenden Rechnereinheit, insbesondere dem Zustandsschätzer (3) und/oder dem Parameterschätzer (4), ausgeführt wird.

## Claims

1. Method for detecting the state of a technical system (1), in which operating variables (x) are measured and supplied to a state estimation routine which determines state variables (a), which characterize the current system state, by means of a model which is based on system-dependent model parameters (p) and the measured operating variables (x), with the measured operating variables (x) and possibly the determined state variables (a) additionally being supplied to a parameter estimation routine in order to improve the state estimation, which parameter estimation routine for its part determines the model parameters (p) in a use-dependent manner, and with state variables (a) and/or parameters (p) which are to be determined by estimation being selected as a function of the dynamics of the measured operating variables (x), **characterized in that** the technical system (1) is an electrical energy store, **in that** the state variables (a) and/or parameters (p) which are not selected are retained in unchanged form or are reset using firmly prescribed models, and **in that** state variables (a) and/or parameters (p) with a small time constant are selected for estimation in the case of high dynamics of the measured operating variables (x), and state variables and/or parameters with a large time constant are selected for estimation in the case of low dynamics.

2. Method according to Claim 1, **characterized in that** it is established whether the system (1) is in a limit state, in particular at the start or at the end of its service life, before the estimation, and **in that** the state variables (a) and/or parameters (p) are not selected for estimation when the system (1) is in such a limit state.

3. Method according to Claim 1 or 2, **characterized in that** the quality of the estimation is monitored using a covariance matrix.

4. Method according to Claim 3, **characterized in that** the estimated state variables (a) and/or parameters (p) are only used further when their associated covariances of the covariance matrix converge.

5. Apparatus for detecting the state of a technical system (1), having means (2) for measuring the operating variables (x) of this system (1), and having means (7) for supplying the measured operating variables (x) to a state estimator (3) which determines state variables (a), which characterize the current system state, by means of a model which is based on system-dependent model parameters (p) and the measured operating variables (x), it being possible for a parameter estimator (4) to be additionally provided in order to improve the state estimation, which parameter estimator can be supplied with the measured operating variables (x) and the determined state variables (a) and determines the model parameters in a use-dependent manner, with means (8) for detecting the dynamics of the measured operating variables (x) and an associated selector unit (9) being provided, **characterized in that** the technical system is an energy store, **in that** the selector unit (9) is designed to select the state variables (a) and/or parameters (p) to be determined in the state estimator and/or parameter estimator (4) as a function of the detected dynamics, and **in that** means are provided which select state variables (a) and/or parameters (p) with small time constants for estimation in the case of high dynamics of the measured operating variables (x), and select state variables and/or parameters with a large time constant for estimation in the case of low dynamics, and which retain the state variables (a) and/or parameters (p) which are not selected in unchanged form or reset said state variables and/or parameters using firmly prescribed models.

6. Apparatus according to Claim 5, **characterized in that** means (10) for calculating a covariance matrix for the state variables (a) and/or parameters (p) to be determined and means (11) for evaluating the resulting covariance matrix are provided.

7. Computer program with program-code means for carrying out all of the steps of at least one of Claims 1 to 4 when the computer program is run on a computer or a corresponding computer unit, in particular on the state estimator (3) and/or parameter estimator (4).

8. Computer-program product with program-code means, which are stored on a computer-readable data-storage medium, for carrying out a method according to one of Claims 1 to 4 when the computer-program product is run on a computer or a corresponding computer unit, in particular the state estimator (3) and/or the parameter estimator (4).

## Revendications

1. °) Procédé de détermination de l'état d'un système technique (1), selon lequel on mesure des grandeurs de fonctionnement (x) et on les transmet à un programme d'évaluation d'état qui détermine au moyen d'un modèle basé sur des paramètres de modèle (p) dépendants du système et sur les grandeurs de fonctionnement (x) mesurées, les grandeurs d'état (a) caractérisant l'état actuel du système et, pour améliorer l'évaluation d'état, on transmet également les grandeurs de fonctionnement (x) mesurées et les grandeurs d'état (a) déterminées à un programme d'évaluation des paramètres qui, pour sa part, détermine les paramètres du modèle (p) en fonction de l'utilisation et, en fonction de la dynamique des grandeurs de fonctionnement (x) mesurées, on effectue une sélection de grandeurs d'état (a) et/ou de paramètres (p) à déterminer par évaluation,
**caractérisé en ce que**
le système technique (1) est un accumulateur d'énergie électrique, les grandeurs d'état (a) ou les paramètres (p) non sélectionnés sont maintenus sans changement ou fixés à nouveau par des modèles fixement prédéterminés, et si la dynamique des grandeurs de fonctionnement (x) mesurées est élevée, on sélectionne des grandeurs d'état (a) ou des paramètres (p) à constante de temps plus faible pour l'évaluation, et des grandeurs d'état ou des paramètres à constante de temps plus grande si la dynamique est plus faible.

2. °) Procédé selon la revendication 1,
**caractérisé en ce qu'**
avant l'évaluation, on constate, si le système (1) se trouve dans un état limite, en particulier au début ou à la fin de sa durée de vie, et les grandeurs d'état (a) ou les paramètres (p) ne sont pas sélectionnés pour l'évaluation si le système (1) se trouve dans un tel état limite.

3. °) Procédé selon la revendication 1 ou 2,
**caractérisé en ce que**
la qualité de l'évaluation est contrôlée à l'aide d'une matrice de covariance.

4. °) Procédé selon la revendication 3,
**caractérisé en ce que**
les grandeurs d'état (a) ou les paramètres (p) évalués ne sont ensuite utilisés que si leurs covariances associées concordent avec la matrice de covariance.

5. °) Dispositif de détermination de l'état d'un système technique (1), comportant des moyens (2) de mesure des grandeurs de fonctionnement (x) de ce système (1) et des moyens (7) de transmission des grandeurs de fonctionnement (x) mesurées à un évaluateur d'état (3) qui détermine des grandeurs d'état (a) caractérisant l'état actuel du système au moyen d'un modèle basé sur des paramètres de modèle (p) dépendants du système et les grandeurs de fonctionnement (x) mesurées, et pour améliorer l'évaluation de l'état, en plus un évaluateur de paramètres (4) auquel les grandeurs de fonctionnement (x) mesurées et les grandeurs d'état (a) déterminées sont transmises et qui détermine les paramètres du modèle en fonction de l'utilisation, dans lequel on prévoit des moyens (8) de détermination de la dynamique des grandeurs de fonctionnement (x) mesurées et une unité de sélection (9) qui lui est liée,
**caractérisé en ce que**
le système technique est un accumulateur d'énergie, l'unité de sélection (9) est conçue pour sélectionner, en fonction de la dynamique déterminée, les grandeurs d'état (a) ou paramètres (p) à déterminer, dans l'évaluateur d'état et/ou l'évaluateur de paramètres (4), et des moyens sélectionnent, pour l'évaluation, des grandeurs d'état (a) ou des paramètres (p) à constante de temps plus faible si la dynamique des grandeurs de fonctionnement (x) mesurées est plus élevée, des grandeurs de fonctionnement ou des paramètres à constante de temps plus grande si la dynamique est plus faible, et les grandeurs d'état (a) ou les paramètres (p) non sélectionnés sont maintenus sans changement ou fixés à nouveau par des modèles fixement prédéterminés.

6. °) Dispositif selon la revendication 5,
**caractérisé en ce qu'**
on prévoit des moyens (10) pour le calcul d'une matrice de covariance pour les grandeurs de l'état (a) ou les paramètres (p) à déterminer et des moyens (11) pour l'évaluation de la matrice de covariance établie.

7. °) Programme informatique avec moyens de code de programme pour réaliser toutes les étapes d'au moins l'une des revendications 1 à 4, lorsque le programme informatique est exécuté sur un ordinateur ou une unité de calcul appropriée, en particulier sur l'évaluateur d'état (3) et/ ou l'évaluateur de paramètres (4).

8. °) Programme informatique avec moyens de code de programme enregistrés sur un support de données lisible par ordinateur, pour exécuter un procédé selon l'une des revendications 1 à 4, lorsque le produit du programme informatique est exécuté sur un ordinateur ou une unité de calcul appropriée, en particulier sur l'évaluateur d'état (3) et/ou l'évaluateur de paramètres (4).
